# EUROPEAN PATENT APPLICATION

(11) **EP 4 822 368 A1**
(43) Date of publication of application: **14.10.2026**
(21) Application number: 26171572.6
(22) Date of filing: 10.04.2026
(51) Int. Cl.: G01R 31/382, G01R 31/392

(54) **DETERMINATION OF A RELAXATION STATE OF A BATTERY**

(30) Priority: 11.04.2025 EP 25170051
(71) Applicant: Volvo Truck Corporation, 405 08 Göteborg (SE)
(72) Inventor: FRANCO JARAMILLO, José Roberto, Göteborg (SE); ABDELKHALEQ, Ghassan, Göteborg (SE)
(74) Representative: Ström & Gulliksson AB

(57) **Abstract**

A computer system and computer-implemented method are disclosed for determining a relaxation state of a battery cell online. The computer-implemented method comprises: acquiring, by processing circuitry of a computer system, a first derivative of a terminal voltage of the battery cell between a first time and a second time later than the first time; acquiring, by the processing circuitry, a second derivative of the terminal voltage of the battery cell between the second time and a third time later than the second time; and determining, by the processing circuitry, a relaxation state of the battery cell online by: comparing the first derivative and the second derivative to at least one threshold; or retrieving a previously determined relaxation state of the battery cell.

## Description

### TECHNICAL FIELD

The disclosure relates generally to battery management. In particular aspects, the disclosure relates to determination of a relaxation state of a battery. The disclosure can be applied in heavy-duty vehicles, such as trucks, buses, multi-unit vehicle combinations, and construction equipment. The disclosure can also be applied to marine vessels, such as water crafts, motorboats, work boats, sport vessels, boats, ships, among other vessel types. The disclosure can also be applied to test environments for batteries. Although the disclosure may be described with respect to a particular implementation, the disclosure is not restricted to any particular implementation. The disclosure can also be applied to other systems such as industrial systems and static systems.

### BACKGROUND

Electrical systems such as electric vehicles are often powered from a battery, such as a battery pack or module comprising a number of battery cells. After operation of a battery, i.e. when a load is removed or charging/discharging has stopped, the battery presents a transient behaviour reaching a steady state. This occurs due to the redistribution of ions, internal chemical processes, and rebalancing of charge within the battery. The time lapsed to reach the steady state is called the relaxation time. A battery can be in a fully or partially relaxed state.

Battery relaxation is an important factor in battery management systems (BMS), as it affects state of charge (SoC) estimation and overall battery health. In a BMS, the relaxation state and relaxation time are therefore important inputs for algorithms running in the BMS. Furthermore, the voltage after the relaxation time is a relevant metric to evaluate the performance of the battery, since it can affect its capability to deliver power and energy to a load.

The relaxation state of a battery may depend on a number of factors, such as SoC, battery chemistry, and operating temperature. The partial relaxation of the cell can be used to provide a rough estimation of the cell dynamics. In contrast, full relaxation is required to increase accuracy in the cell estimation dynamics and is the base for other control algorithms. Therefore, estimating the relaxation state accurately is desirable.

The relaxation time of a battery may also depend on several factors, such as the polarity of the current (charging or discharging), rate of the current, state of health (SoH), and operating temperature. Therefore, estimating the relaxation time accurately can be challenging. Moreover, to provide a degree of confidence, it is desirable to understand the relaxation time effect with proper bounds.

It is therefore desired to provide systems, methods and other approaches that attempt to resolve or at least mitigate one or more of these issues.

### SUMMARY

This disclosure provides systems, methods and other approaches for determining a relaxation state of a battery cell online. In particular, the relaxation state of a battery cell can be determined based on the derivative of a terminal voltage of the battery cell over time. This is performed online (e.g. dynamically) and uses numerical methodologies to determine the relaxation state, thereby taking system dynamics such as current, temperature, and state of charge into account. As such, it is not required to determine or store parameter or operation information in advance and the computational efficiency of the method is increased. Furthermore, differentiation between partial and full relaxation of the battery cell is provided. This enables a relaxation state to be determined in an adaptable fashion for different cell types and operating conditions as it does not depend on the battery cell chemistry itself. Different implementation issues such as current cutoffs and voltage measurement noise are also taken care of.

According to a first aspect of the disclosure, there is provided a computer system for determining a relaxation state of a battery cell online, the computer system comprising processing circuitry configured to: acquire a first derivative of a terminal voltage of the battery cell between a first time and a second time later than the first time; acquire a second derivative of the terminal voltage of the battery cell between the second time and a third time later than the second time; and determine the relaxation state of the battery cell online by: comparing the first derivative and the second derivative to at least one threshold; or retrieving a previously determined relaxation state of the battery cell.

The first aspect of the disclosure may seek to provide an approach for determining a relaxation state of a battery cell that can be performed online and takes system dynamics such as current, temperature, and state of charge into account. This means that it is not required to determine or store parameter or operation information in advance and the computational efficiency of the method is increased and parameter uncertainties due to cell aging are avoided. A technical benefit may include enabling improved accuracy of online battery state estimation by providing a computationally simple trigger based on voltage stability. A discrete state machine is provided with memory, hysteresis, and temporary calculations based on successive window derivatives. The concept of using a derivative directly is enhanced with to minimise measurement noise, false positives, and maintain the relaxation state when appropriate.

Optionally in some examples, including in at least one preferred example, if a current associated with the battery cell is below a first current threshold the processing circuitry is configured to determine that the battery cell is in a fully relaxed state if: the first derivative and the second derivative are below a first threshold; or the previously determined relaxation state of the battery cell is a fully relaxed state. A technical benefit may include enabling a reliable trigger for actions that require a stable open-circuit voltage, such as state-of-health diagnostics.

Optionally in some examples, including in at least one preferred example, if a current associated with the battery cell is below a first current threshold the processing circuitry is configured to determine that the battery cell is in a partially relaxed state if: the first derivative and the second derivative are above a first threshold and below a second threshold; or the previously determined relaxation state of the battery cell is a partially relaxed state. A technical benefit may include allowing for more nuanced battery management strategies that can adapt to different levels of voltage stability.

Optionally in some examples, including in at least one preferred example, if a current associated with the battery cell is above the first current threshold and below a second current threshold, the processing circuitry is configured to determine that the battery cell is in a partially relaxed state if: the first derivative and the second derivative are below a second threshold; or the previously determined relaxation state of the battery cell is a partially relaxed state. A technical benefit may include improving the robustness of the relaxation state determination across a wider range of low-load operating conditions.

Optionally in some examples, including in at least one preferred example, the processing circuitry is configured to determine the relaxation state of the battery cell online by retrieving a previously determined relaxation state of the battery cell if the current associated with the battery cell has remained under the relevant current threshold between the second time and the third time. A technical benefit may include reducing the computational load by avoiding redundant calculations when the battery's operating conditions are stable.

Optionally in some examples, including in at least one preferred example, the previously determined relaxation state of the battery cell corresponds to the second time (k-l). A technical benefit may include ensuring temporal consistency in the state determination logic by explicitly comparing consecutive derivatives of the terminal voltage of the battery cell.

Optionally in some examples, including in at least one preferred example, the processing circuitry is configured to determine a derivative, *∇Vₜ*(*k*), according to: $∇ {V}_{t} \left(k\right) = \left|\frac{{V}_{t} \left(k\right) - {V}_{t} \left(k-l\right)}{{lT}_{s}}κ\right|$ where *κ* is an amplitude factor and *Tₛ* is a sampling period. A technical effect may include that the use of clear and reproducible numerical methodologies enables system dynamics such as current, temperature, and state of charge to be taken into account. As such, it is not required to determine or store parameter or operation information in advance and the computational efficiency of the method is increased, and parameter uncertainties due to cell aging are avoided.

Optionally in some examples, including in at least one preferred example, the third time is a current time. A technical effect may include that the relaxation state may be determined in real-time using the most recent data available for real-time control and without knowledge of system parameters in advance.

Optionally in some examples, including in at least one preferred example, the processing circuitry is configured to acquire the first derivative and the second derivative in response to determining that a current associated with the battery cell has dropped below an initiation current threshold. A technical effect may include that the method is not performed until the battery cell is in a suitable state for a relaxation analysis to be performed, e.g. when a load is removed or charging/discharging has stopped, thereby improving computational efficiency

Optionally in some examples, including in at least one preferred example, the processing circuitry is further configured to determine a relaxation time of the battery cell in response to determining the relaxation state. A technical effect may include that a relaxation time corresponding to a determined relaxation state can also be provided for further control and assessment of battery performance, such as analysis or model parameterization.

Optionally in some examples, including in at least one preferred example, the processing circuitry is further configured to: determine a relaxation state of one or more other battery cells comprised in a battery module comprising the battery cell; and determine a relaxation state of the battery module based on respective relaxation states of the battery cells comprised in the battery module. A technical effect may include that a relaxation state of a multi-cell battery module may be determined online taking system dynamics into account and avoiding parameter uncertainties.

Optionally in some examples, including in at least one preferred example, the processing circuitry is configured to determine a relaxation state, *xᵣₘ,* for the battery module according to: ${x}_{rm} \left(k\right) = {min}_{j = 1}^{n} \left\{{x}_{rj}\left(k\right)\right\} ,$ where n is the number of cells in the module, *xᵣⱼ* is the relaxation state of the j-th cell, and *min* is the minimum value of a set of cells. A technical effect may include that numerical methodologies are provided to determine a relaxation state of a battery module.

According to a second aspect of the disclosure, there is provided a vehicle comprising the computer system of the first aspect. The second aspect of the disclosure may seek to provide a vehicle capable of determining a relaxation state of a battery cell or module that can be performed online taking system into account and avoiding parameter uncertainties.

According to a third aspect of the disclosure, there is provided a computer-implemented method for determining a relaxation state of a battery cell online, the computer-implemented method comprising: acquiring, by processing circuitry of a computer system, a first derivative of a terminal voltage of the battery cell between a first time and a second time later than the first time; acquiring, by the processing circuitry, a second derivative of the terminal voltage of the battery cell between the second time and a third time later than the second time; and determining, by the processing circuitry, a relaxation state of the battery cell online by: comparing the first derivative and the second derivative to at least one threshold; or retrieving a previously determined relaxation state of the battery cell.

The third aspect of the disclosure may seek to provide an approach for determining a relaxation state of a battery cell that can be performed online and takes system dynamics such as current, temperature, and state of charge into account. This means that it is not required to determine or store parameter or operation information in advance and the computational efficiency of the method is increased and parameter uncertainties due to cell aging are avoided. A technical benefit may include enabling improved accuracy of online battery state estimation by providing a computationally simple trigger based on voltage stability. A discrete state machine is provided with memory, hysteresis, and temporary calculations based on successive window derivatives. The concept of using a derivative directly is enhanced with to minimise measurement noise, false positives, and maintain the relaxation state when appropriate.

According to a fourth aspect of the disclosure, there is provided a computer program product comprising program code for performing, when executed by processing circuitry, the computer-implemented method of the third aspect. The fourth aspect of the disclosure may seek to enable new vehicles and/or legacy vehicles to be conveniently configured, by software installation/update, to determine a relaxation state of a battery cell or module that can be performed online taking system into account and avoiding parameter uncertainties.

According to a fifth aspect of the disclosure, there is provided a non-transitory computer-readable storage medium comprising instructions, which when executed by processing circuitry, cause the processing circuitry to perform the computer-implemented method of the third aspect. The fifth aspect of the disclosure may seek to enable new vehicles and/or legacy vehicles to be conveniently configured, by software installation/update, to determine a relaxation state of a battery cell or module that can be performed online taking system into account and avoiding parameter uncertainties.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** schematically shows a side view of a vehicle according to an example of the disclosure.
**FIG. 2** illustrates a battery module comprising a number of battery cell according to an example of the disclosure.
**FIG. 3A** is a flow chart of a computer-implemented method according to an example of the disclosure.
**FIG. 3B** is a flow chart of a computer-implemented method according to an example of the disclosure.
**FIG. 4** is a schematic diagram of a computer system for implementing examples disclosed herein.

Like reference numerals refer to like elements throughout the description.

### DETAILED DESCRIPTION

The detailed description set forth below provides information and examples of the disclosed technology with sufficient detail to enable those skilled in the art to practice the disclosure.

Battery relaxation is an important factor in BMSs, as it affects SoC estimation and overall battery health. In a BMS, the relaxation state and relaxation time are therefore important inputs for algorithms running in the BMS. Furthermore, the voltage after the relaxation time is a relevant metric to evaluate the performance of the battery, since it can affect its capability to deliver power and energy to a load. The relaxation state of a battery may depend on a number of factors, such as SoC, battery chemistry, and operating temperature. The relaxation time of a battery may also depend on several factors, such as the polarity of the current (charging or discharging), rate of the current, SoH, and operating temperature. The partial relaxation of the cell can be used to provide a rough estimation of the cell dynamics. In contrast, full relaxation is required to increase accuracy in the cell estimation dynamics and is the base for other control algorithms. Therefore, estimating the relaxation state and time accurately is challenging.

To remedy this, systems, methods and other approaches are provided for determining a relaxation state of a battery cell online. In particular, the relaxation state of a battery cell can be determined based on the derivative of a terminal voltage of the battery cell over time. This is performed online (e.g. dynamically) and uses numerical methodologies to determine the relaxation state, thereby taking system dynamics such as current, temperature, and state of charge into account. As such, it is not required to determine or store parameter or operation information in advance and the computational efficiency of the method is increased. Furthermore, differentiation between partial and full relaxation of the battery cell is provided. This enables a relaxation state to be determined in an adaptable fashion for different cell types and operating conditions as it does not depend on the battery cell chemistry itself. Different implementation issues such as current cutoffs and voltage measurement noise are also taken care of.

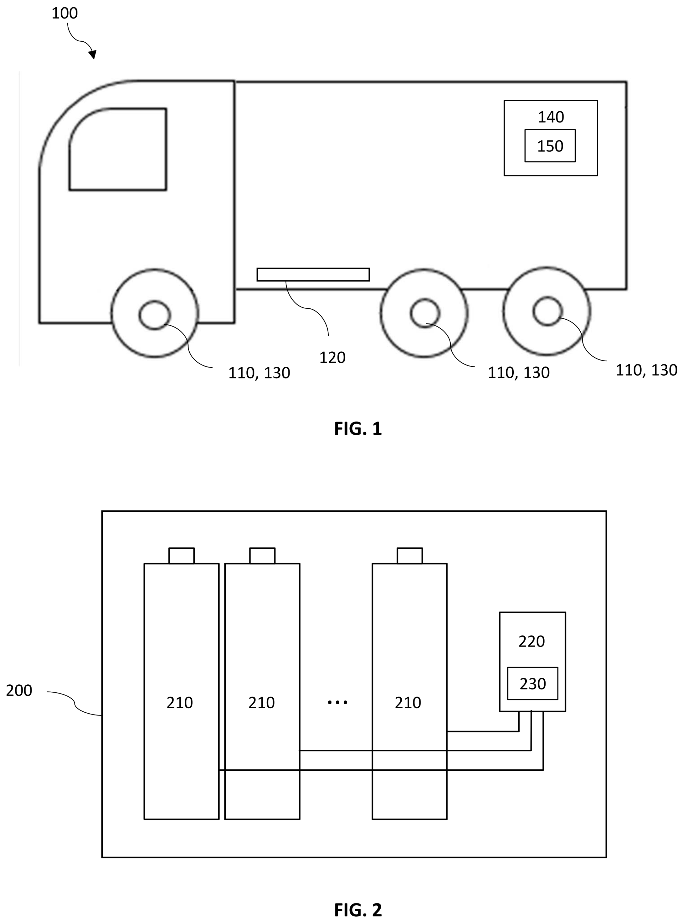

**FIG. 1** schematically shows a side view of an example vehicle **100** of the type considered in this disclosure. The vehicle **100** may be any suitable form of vehicle. For example, the disclosure can be applied in heavy-duty vehicles, such as trucks, buses, and construction equipment, in personal vehicles such as cars, vans, or motorbikes, or in marine vessels. The present disclosure is also applicable to any type of battery system, not only battery systems for vehicles.

The vehicle **100** comprises a number of axles, each generally having two or more wheels. Whilst three axles are shown, it will be appreciated that any suitable number of axles may be provided. It will also be appreciated that any number of the axles may be driven axles.

The vehicle **100** comprises one or more sources of propulsion. For example, the vehicle **100** may comprise one or more electrical machines **110** such as electric motors and/or generators. The vehicle **100** may comprise one or more batteries **120** configured to provide power to the electrical machines **110** and/or other functions of the vehicle **100.** As such, the vehicle **100** is an at least partly electrically propelled vehicle **100.** In some examples, the vehicle **100** may also include another source of propulsion, for example an internal combustion engine (ICE). In some examples, the vehicle **100** may be propelled solely by an ICE. In such examples, the batteries **120** may be used to power electronics controlling the ICE (fuel injection, etc.) or other systems of the vehicle (thermal control of a cabin of the vehicle, auxiliary equipment such as refrigerators, GPS etc.).

The electrical machines **110** are configured to drive, e.g. provide torque and/or steering to, one or more axles or individual wheels of the vehicle **100.** The electrical machines **110** can supply either a positive (propulsion) or negative (braking) force. The use of electrical machines **110** to supply a negative force is known as regenerative braking, in which case the electrical machines **110** may be operated as generators, in order to recover energy during braking. The energy recovered from regenerative braking can be stored in the battery **120.**

The battery **120** provides electrical energy to components of the vehicle **100** that require electrical power. The battery **120** is typically rechargeable and is typically a lithium-ion battery, although other types of battery will be readily envisaged. The battery **120** may be a battery pack or module comprising one or more battery cells. The battery **120** may be controlled by a battery management system (BMS) that may perform tasks such as monitoring the state of the battery **120,** calculating and transmitting data about the battery **120,** high voltage control, protection, diagnostics, and the like. The vehicle **100** may comprise a plurality of batteries or battery modules **120.** A battery module **200** is disclosed in more detail in relation to **FIG. 2****.**

The vehicle **100** may also comprise one or more sets of service brakes **130.** The service brakes **130** can supply a negative (braking) force. The service brakes **130** may be, for example, frictional brakes such as pneumatic brakes. Pneumatic brakes use a compressor to fill the brake with air, which may be powered by the batteries. In some examples, the brakes may be electro-mechanical brakes.

In the example of **FIG. 1****,** the vehicle **100** includes a controller in the form of a computer system **140** comprising processing circuitry **150.** The computer system **140** may be a vehicle control unit configured to perform various vehicle (unit) control functions, such as vehicle motion management and power control. For example, the computer system **140** may be configured to control components of the vehicle, for example the electrical machines **110** and the battery **120.** The computer system **140** may receive control signals from a remote system, implemented at a distance from the vehicle **100.** The computer system **140** may be communicatively coupled to the remote system in any suitable way, for example via a circuit or any other wired, wireless, or network connection known in the art. Furthermore, the communicative coupling may be implemented as a direct connection between the computer system **140** and the remote system or may be implemented as a connection via one or more intermediate entities.

The vehicle **100** may be a vehicle combination comprising a number of units, including a tractor unit and at least one trailing unit. In some examples, the vehicle **100** may be a vehicle combination comprising a number of units, including a tractor unit and at least one trailing unit. In such examples, each unit may comprise its own electrical machines **110,** battery **120,** service brakes **130,** and the like. In examples where the vehicle **100** is a vehicle combination, the vehicle **100** may include a global controller and a plurality of unit controllers, for example a controller for each unit.

**FIG. 2** illustrates a battery pack or module **200** comprising a number of battery cells **210.** The battery module **200** may be used to implement the battery **120** of the vehicle **100** shown in **FIG. 1****.** Such a battery module **200** can be used in vehicles, for example for providing power to electric motors and other electrically driven components of the vehicle. The battery module **200** may be part of an energy storage system (ESS), such as a battery energy storage system (BESS), which may be an ESS of a vehicle, e.g. the vehicle **100,** or of another system such as industrial system or static system.

The battery module **200** of **FIG.** 2 is shown as comprising three battery cells **210,** but the battery module **200** may comprise any suitable number of battery cells **210.** The battery cells **210** may be any suitable form of battery cell. The battery cells **210** are communicatively coupled to a battery management unit (BMU) **220,** for example as known in the art. The BMU **220** is configured to monitor, control and/or manage various aspects of the operation of the battery cells **210** ensure the optimal performance, longevity, and safety of the battery module **200.** For example, the BMU **220** may perform cell monitoring, balancing, state of charge (SoC) estimation, SoH monitoring, safety management, thermal management, and/or communication for the battery module **200.** The BMU **220** may be implemented, for example, via code running on a processing circuitry, or similar. The BMU **220** may comprise processing circuitry **230** configured to implement various operations disclosed below. The BMU **220** may include a memory storing instructions that, when executed by the processing circuitry **230,** cause the processing circuitry **230** to perform the various operations. In some examples, the BMU **220** may be communicatively coupled to the computer system **140** shown in **FIG. 1****,** for example as known in the art. In some examples, the BMU **220** may be implemented as part of the computer system **140.** In some examples, the BMU **220** may constitute or be implemented as part of a BMS as discussed above.

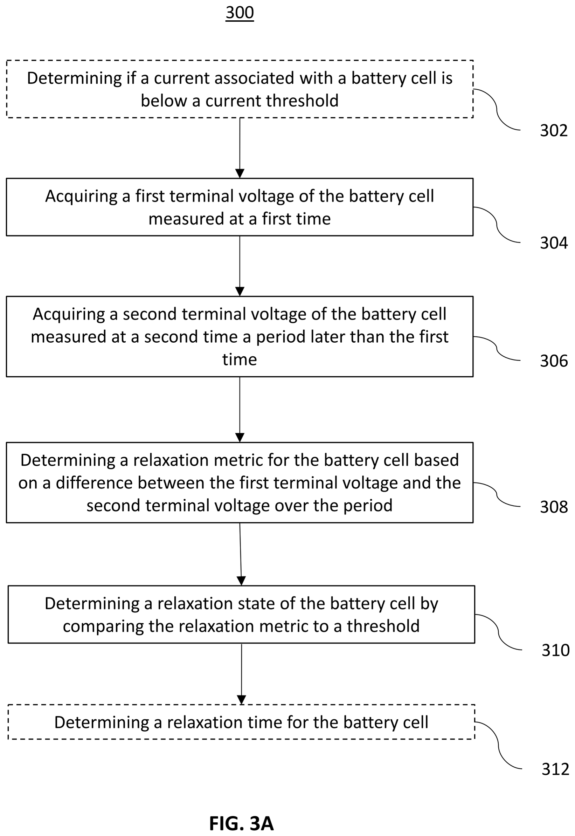

**FIG. 3A** is a flow chart of a computer-implemented method **300** according to an example. The method **300** enables the determination of a relaxation state of a battery cell **210** online. In particular, the method **300** is based on determining a relaxation metric for the battery cell **210** based on a derivative of the terminal voltage of the cell **210,** and comparing the relaxation metric to a threshold. The method is performed online (e.g. dynamically), meaning that the relaxation state can be determined in an adaptable fashion for different cell types and operating conditions, and it is not required to determine or store parameter or operation information in advance. The method **300** may be implemented by processing circuitry of a computer system (e.g., the processing circuitry **150** of the computer system **140** described in relation to **FIG. 1** or the processing circuitry **230** of the BMU **220** described in relation to **FIG. 1****).**

At **302,** a current associated with the battery cell **210** may be compared to a threshold to determine if the battery cell **210** is in a suitable state for a relaxation analysis to be performed, e.g. when a load is removed or charging/discharging has stopped. For example, when the current is sufficiently low, it may be determined that the battery cell **210** is entering a relaxation state. It may then be desired to determine the relaxation state and an associated relaxation time. The current may be sampled periodically and/or may be sampled once a load is disconnected from the battery cell **210** or charging/discharging has stopped. The current may be sampled at a rate corresponding to a sampling period *Tₛ*, which may be determined by the skilled person. The sampling period *Tₛ* may be, for example, 20 ms, 40 ms, or 100 ms.

At **304,** a first terminal voltage *Vₜ*(*k*) of the battery cell **210** is acquired, The first terminal voltage *Vₜ*(*k*) is measured at a first time (or timestep) *k.* The first terminal voltage *Vₜ*(*k*) may be sampled at the same rate as the current. The first time (or timestep) *k* may therefore correspond to the first sample taken after determining at **302** that the current has fallen below a relevant threshold. In some embodiments, voltage sampling may be initiated only once it has been determined at **302** that the current has fallen below a relevant threshold.

The first terminal voltage *Vₜ*(*k*) may be measured directly at a terminal of the battery cell **210** using any suitable means known in the art. In model- or table-based algorithms, the parameters of the battery cell **210** are typically based on beginning of life values. However, these parameters may change as the battery cell **210** ages, meaning the implemented parameter values may not reflect the real values, leading to parameter uncertainties. By measuring the voltage directly at the terminal, the real voltage in the battery cell **210** is provided. Moreover, no intrinsic parameters of the battery cell **210** are used. Measuring the voltage directly at the terminal therefore ensures the following steps of the method **300** are not affected by parameter uncertainties.

At **306,** at a second time (or timestep) *k + l,* a second terminal voltage *Vₜ*(*k+l*) of the battery cell **210** is measured. The second time *k + l* is later than the first time *k.* In particular, the second time *k* is a number *l* of sampling periods *Tₛ* later than the first time *k* (i.e. the time difference between the first time *k* and the second time *k + l* is a multiple *l* of the sampling period *Tₛ*). In some examples, the second time *k + l* is one sampling period *Tₛ* later than the first time *k.* The second terminal voltage *Vₜ*(*k*) may also be measured directly at a terminal of the battery cell **210.**

In some examples, the second time *k + l* is at or close to the current time, i.e. the method **300** is performed in real-time. As discussed above, the method **300** is performed online (e.g. dynamically), so that a relaxation state can be determined without knowledge of system parameters in advance.

At **308,** a relaxation metric R for the battery cell **210** is determined. The relaxation metric *R* is based on a difference between the first terminal voltage *Vₜ*(*k*) and the second terminal voltage *Vₜ*(*k + l*) over the period *lTₛ* between the measurements. That is to say, the relaxation metric *R* is determined based on a derivative of the terminal voltage of the cell **210** over the period *lTₛ* between the measurements. As discussed above, the period between the measurements is a multiple *l* of the sampling period *Tₛ*, and may correspond to a single sampling period *Tₛ*. The derivative of the terminal voltage of the cell **210** when the current is close to zero may be relatively low. This means that the relaxation metric *R* does not need to be determined in the order of milliseconds. Instead, the method can be performed in the order of minutes, reducing the associated computational workload.

In some examples, the derivative is multiplied by an amplitude factor *κ* to determine the relaxation metric *R*. The amplitude factor *κ* enables better computation and parameter selection by scaling up small values given by the derivative. The amplitude factor *κ* may be set by the skilled person based on the parameters and operating conditions of the system at hand.

In some examples, the relaxation metric *R* may therefore be determined according to: $R = \left|\frac{{V}_{t} \left(k+l\right) - {V}_{t} \left(k\right)}{{lT}_{s}}κ\right|$ (1) The absolute value of the relaxation metric *R* may be determined for simple comparison to one or more thresholds.

At **310,** the relaxation metric *R* is compared to one or more thresholds to determine a relaxation state of the battery cell **210.** This is performed online (e.g. dynamically), and the relaxation state can be determined in an adaptable fashion for different cell types and operating conditions. In particular, a first threshold *β*₁ may be applied in relation to a fully relaxed state, while a second threshold *β*₂ may be applied in relation to a partially relaxed state. The thresholds may be set by the skilled person based on the parameters and operating conditions of the system at hand. For example, the thresholds may be set based on voltage measurement noise, residual currents, and/or the chemistry of the battery cell **210.** In some examples, a measurement of the voltage of the battery cell **210** may be determined in an offline experiment upon which a derivative and appropriate thresholds can be determined. Even if such thresholds are set at the beginning of battery life, they are valid for the whole life of the battery cell and the proposed approach is therefore robust against cell aging.

The first threshold *β*₁ may be set to determine when the battery cell **210** is in a fully relaxed state. For example, when the derivative of the terminal voltage of the cell **210** is close to zero, the voltage tends to converge to the open circuit voltage (OCV) of the battery cell **210.** This is indicative of full relaxation. As such, the first threshold *β*₁ can be set close to zero to determine when the voltage is not changing and conclude that the battery cell **210** is relaxed. An associated advantage is that, when full relaxation is determined, the terminal voltage of the cell **210** is known (i.e. close or equal to the OCV). The voltage of the cell **210** after relaxation is a relevant metric to evaluate the performance of the battery cell **210,** since it can affect the capability performance of the battery cell **210** to deliver power and energy to an application. Full relaxation is required to increase accuracy in the cell estimation dynamics and is the base for other control algorithms. For example, for SoC recalibration, the system needs to be fully relaxed or the SoC recalibration will not trigger, meaning SoC errors will be gradually increasing. Furthermore, the system needs to be fully relaxed to trigger capacity measurements used in SoH calculation of the battery cell **210.** As such, if a fully relaxed state is determined incorrectly, e.g. when the system is not fully relaxed, inaccuracies will appear in the SoC and SoH estimations that will reduce the lifespan of the battery cell **210** and affect performance.

The second threshold *β*₂ may be larger than the first threshold *β*₁. If the derivative of the terminal voltage of the cell **210** is relatively large, there is no convergence to the open circuit voltage OCV and it can be determined that the cell is not fully relaxed, i.e. it is in a partially relaxed state. The second threshold *β*₂ may be set to take any current cutoffs for the battery cell **210** into account. The partial relaxation of the cell can be used to provide a rough estimation of the cell dynamics. For example, instead of waiting for a full relaxation state to be achieved, monitoring relaxation over a shorter period can provide insight into the time constants and dynamic response of the battery cell **210.** Furthermore, even a partial relaxation can be useful in approximating how the voltage of the battery cell **210** evolves with SoC and can be used to refine SoC estimation algorithms. Comparing the relaxation profile over repeated cycles can help detect degradation trends, such as increased internal resistance or slower diffusion.

To determine the relaxation state *xᵣ,* a function may be defined as follows: ${x}_{r} = \left\{\begin{matrix}2 & \left|\frac{{V}_{t} \left(k+l\right) - {V}_{t} \left(k\right)}{{lT}_{s}}κ\right| < {β}_{1} , \\ 1 & \left|\frac{{V}_{t} \left(k+l\right) - {V}_{t} \left(k\right)}{{lT}_{s}}κ\right| < {β}_{2} , \\ 0 & Otherwise ,\end{matrix}\right.$ (2) where, the battery cell **210** is determined to be in a partially relaxed state if the function outputs a value of 1 and in a fully relaxed state if the function outputs a value of 2. A value of 0 may be output when the battery cell **210** is not partially or fully relaxed, for example when there is transitory behaviour in the dynamics of the battery cell **210.** This may be the case, for example, when fast charging of the battery cell **210** is performed before the load disconnection.

At **312,** a relaxation time for the battery cell **210** corresponding to the determined relaxation state *xᵣ* may be determined. In particular, when the determination of the relaxation state *xᵣ* is performed online, a partial or full relaxation state (i.e. when the relaxation metric R meets the respective threshold) can be determined at a specific time. This can be determined based on the the number of timesteps that have elapsed from the method being triggered (i.e. determining at **302** that the current has below a certain threshold) to the relaxation metric *xᵣ* meeting the respective threshold.

The method **300** enables the determination of a relaxation state *xᵣ* of a battery cell **210** to be performed online. Furthermore, differentiation between partial and full relaxation of the battery cell **210** is provided. The method **300** is performed online (e.g. dynamically), and uses numerical methodologies to determine the relaxation state taking system dynamics such as current, temperature, and state of charge into account, meaning it is not required to determine or store parameter or operation information in advance and the computational efficiency of the method is increased. In this way, and by measuring voltage directly at the terminal, parameter uncertainties due to cell aging are avoided. The method **300** enables the relaxation state to be determined in an adaptable fashion for different cell types and operating conditions. The method **300** does not depend on the battery cell chemistry itself and can be parameterized to any chemistry and any module to obtain the best performance, for example via appropriate setting of the thresholds. The method **300** can deal with different implementation issues such as current cutoffs and voltage measurement noise. For example, different BMSs may have different cutoff currents due to secondary sources of energy delivery. Therefore, model- or table-based algorithms will not work properly under the same operating conditions. The presented thresholds enable current cutoffs to be parameterised and can be set to take care of voltage measurement noise. Proper and appropriate implementation of a low pass filter before the voltage measurements are used in the method **300** may also take care of voltage measurement noise.

The method **300** may also be used to determine a relaxation state and time of the battery pack or module **200.** In particular, the method **300** may also be used to determine a relaxation metric of one or more of the other battery cells **210** comprised in the battery module **200** and determine a relaxation metric of the battery module **200** based on respective relaxation metrics of the battery cells **210.** A relaxation metric *Rₘ* for the battery module **200** may be determined according to: ${R}_{m} = {min}_{j = 1}^{n} \left\{{R}_{j}\right\} ,$ (3) where n is the number of cells **210** in the module **200,** *Rⱼ* is the relaxation metric of the *j*-th cell **210,** and *min* is the minimum value of a set of cells **210.** The relaxation state and time of the battery module **200** may then be determined in the same manner as for the battery cells **210,** as discussed above.

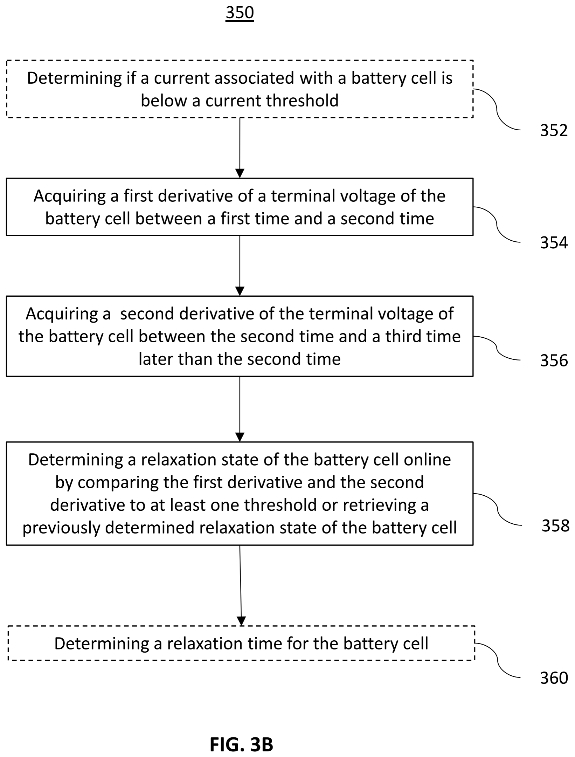

**FIG. 3B** is a flow chart of computer-implemented method **350** according to another example. The method **400** also enables the determination of a relaxation state of a battery cell **210** online. In particular, the method **350** is based on determining a relaxation metric for the battery cell **210** based on consecutive derivatives of the terminal voltage of the cell **210.** The method is performed online (e.g. dynamically), meaning that the relaxation state can be determined in an adaptable fashion for different cell types and operating conditions, and it is not required to determine or store parameter or operation information in advance. The method **350** may be implemented by processing circuitry of a computer system (e.g., the processing circuitry **150** of the computer system **140** described in relation to **FIG. 1** or the processing circuitry **230** of the BMU **220** described in relation to **FIG. 1****).**

At **352,** a current associated with the battery cell **210** may be compared to a threshold to determine if the battery cell **210** is in a suitable state for a relaxation analysis to be performed, e.g. when a load is removed or charging/discharging has stopped. This may be performed in the same manner as discussed in relation to step **302** in the method **300.** The current may be sampled periodically and/or may be sampled once a load is disconnected from the battery cell **210** or charging/discharging has stopped. The current may be sampled at a rate corresponding to a sampling period *Tₛ*, which may be determined by the skilled person. The threshold may be referred to as an initiation current threshold, and step **352** may act as a trigger for the following steps.

At **354,** a first derivative *∇Vₜ*(*k - l*) of a terminal voltage *Vₜ* of the battery cell **210** is acquired. The first derivative is between a first time (or timestep) *k -* 2*l* and a second time (or timestep) *k* - *i,* later than the first time *k -* 2*l.* In particular, the second time *k - l* is a number *l* of sampling periods *Tₛ* later than the first time *k -* 2*l* (i.e. the time difference between the first time *k -* 2*l* and the second time *k - l* is a multiple *l* of the sampling period *Tₛ*). In some examples, the second time *k - l* is one sampling period *Tₛ* later than the first time *k -* 2*l.* In some examples, the first derivative *∇Vₜ*(*k - l*) may be determined according to: $∇ {V}_{t} \left(k-l\right) = \left|\frac{{V}_{t} \left(k-l\right) - {V}_{t} \left(k-2l\right)}{{lT}_{s}}κ\right|$ (4) where *κ* is an amplitude factor that enables better computation and parameter selection by scaling up small values given by the derivative. The amplitude factor *κ* may be set by the skilled person based on the parameters and operating conditions of the system at hand.

At **356,** a second derivative *∇Vₜ*(*k*) of a terminal voltage *Vₜ* of the battery cell **210** is acquired. It is noted that the term "second derivative" herein means a second value of the rate of change of the terminal voltage, rather than a mathematical second derivative (i.e. a derivative of a derivative). The second derivative is between the second time (or timestep) *k - l* and a third time (or timestep) *k,* later than the second time *k* - *l.* In particular, the third time *k* is a number *l* of sampling periods *Tₛ* later than the second time *k - l* (i.e. the time difference between the second time *k - l* and the third time *k* is a multiple *l* of the sampling period *Tₛ*). In some examples, the third time *k* is one sampling period *Tₛ* later than the second time *k - l.* In some examples, the second derivative *∇Vₜ*(*k*) may be determined according to: $∇ {V}_{t} \left(k\right) = \left|\frac{{V}_{t} \left(k\right) - {V}_{t} \left(k-l\right)}{{lT}_{s}}κ\right|$ (5) where *κ* is an amplitude factor as discussed above.

In some examples, the third time *k* is at or close to the current time, i.e. the method **350** is performed in real-time. As discussed above, the method **350** is performed online (e.g. dynamically), so that a relaxation state can be determined without knowledge of system parameters in advance.

The terminal voltage *Vₜ* may be sampled at the same rate as the current. The first time *k -* 2*l* may therefore correspond to the first sample taken after determining at **352** that the current has fallen below a relevant threshold. In some embodiments, voltage sampling may be initiated only once it has been determined at **352** that the current has fallen below a relevant threshold. The associated terminal voltages *Vₜ*(*k -* 2*l*), *Vₜ*(*k - l*), *Vₜ*(*k*) may be measured directly at a terminal of the battery cell **210** using any suitable means known in the art. In model- or table-based algorithms, the parameters of the battery cell **210** are typically based on beginning of life values. However, these parameters may change as the battery cell **210** ages, meaning the implemented parameter values may not reflect the real values, leading to parameter uncertainties. By measuring the voltage directly at the terminal, the real voltage in the battery cell **210** is provided. Moreover, no intrinsic parameters of the battery cell **210** are used. Measuring the voltage directly at the terminal therefore ensures the following steps of the method **300** are not affected by parameter uncertainties.

At **358,** a relaxation state *xᵣ*(*k*) of the battery cell **210** is determined. The relaxation state *xᵣ*(*k*) is determined by comparing the first derivative *∇Vₜ*(*k - l*) and the second derivative *∇Vₜ*(*k*) to at least one threshold or retrieving a previously determined relaxation state *xᵣ (k - l*) of the battery cell **210** is determined.

This may be performed according to whether a current *i* associated with the battery cell **210** is (i) below a first (lower) current threshold *i_{cl}* or (ii) above the first current threshold *i_{cl}* but below a second (upper) current threshold *i_{cu}* higher than the first current threshold *i_{cl}.* The value of the current *i* used for the comparison may be the latest sampled current value. These thresholds provide flexibility in how partial and full relaxation are identified. For example, partial relaxation can be triggered in the presence of higher current levels, which is useful, for instance, while the vehicle is working. In contrast, full relaxation is a strict state, which can only be triggered if the current is low, for instance when the vehicle is at rest. The upper current threshold *i_{cu}* may also be used as the initiation current threshold in step **352.** The current thresholds *i_{cl}, i_{cu}* may be set by the skilled person based on the parameters and operating conditions of the system at hand. In some examples, the minimum current flow can be calculated based on the nominal current consumption and set as the current threshold for full relaxation, i.e. *i_{cl}.* The current threshold for partial relaxation *i_{cu}* should be greater than the full relaxation threshold *i_{cl}.* In some examples, the threshold for partial relaxation *i_{cu}* should not be greater than 2% of the nominal capacity of the cell. For instance, if the nominal capacity of the cell is Q=150 Ah, then, the maximum threshold for partial relaxation *i_{cu}* is 3 A.

If the current *i* associated with the battery cell **210** is below the first current threshold *i_{cl},* both full and partial relaxation can be triggered. In this case, the battery cell **210** is determined to be in a fully relaxed state if the first derivative *∇Vₜ*(*k - l*) and the second derivative *∇Vₜ*(*k*) are below a first threshold *β*₁, or if the previously determined relaxation state *xᵣ*(*k - l*) of the battery cell **210** is a fully relaxed state. If the current *i* associated with the battery cell **210** is below the first current threshold *i_{cl},* the battery cell **210** is determined to be in a partially relaxed state if the first derivative *∇Vₜ*(*k - l*) and the second derivative *∇Vₜ*(*k*) are above the first threshold *β*₁ and below a second threshold *β*₂, or if the previously determined relaxation state *xᵣ*(*k - l*) of the battery cell **210** is a partially relaxed state. Otherwise, no relaxation state is determined. The derivative of the terminal voltage of the cell **210** when the current is close to zero may be relatively low. This means that the relaxation metric *xᵣ* does not need to be determined in the order of milliseconds. Instead, the method can be performed in the order of minutes, reducing the associated computational workload.

If the current *i* associated with the battery cell **210** is above the first current threshold *i_{cl}* but below the second current threshold *i_{cu},* only partial relaxation can be triggered. In this case, the battery cell **210** is determined to be in a partially relaxed state if the first derivative *∇Vₜ*(*k - l*) and the second derivative *∇Vₜ*(*k*) are below the second threshold *β*₂, or if the previously determined relaxation state *xᵣ*(*k - l*) of the battery cell **210** is a partially relaxed state. Otherwise, no relaxation state is determined.

The thresholds *β*₁ and *β*₂ may be the same as those discussed in relation to the method **300** and may be determined and applied in the same way. As discussed in relation to the method **300,** the first threshold *β*₁ may be set to determine when the battery cell **210** is in a fully relaxed state, while the second threshold *β*₂ may be set to determine when the battery cell **210** is in a partially relaxed state. The thresholds *β*₁ and *β*₂ may be set by the skilled person based on the parameters and operating conditions of the system at hand. The second threshold *β*₂ may be larger than the first threshold *β*₁.

If the current associated with the battery cell **210** has remained under the relevant current threshold *i_{cl}, i_{cu}* between the second time *k - l* and the third time *k,* the previously determined relaxation state *xᵣ*(*k - l*) of the battery cell **210** is used. This is a form of memory indicating that, once the state is fully or partially relaxed, the relaxation state will be held if the current does not materially change. The purpose of this memory is to avoid changes in the determined relaxation state due to measurement noise. Furthermore, if the relevant current threshold is transgressed then the memory disappears, it can be ensured that the current sampling time is sufficiently small, e.g. 20ms. Moreover, if there is a current change, it will be detected in the voltage measurements where the transient behaviour is slower, meaning it can be detected using the disclosed approach. The previously determined relaxation state *xᵣ* (*k - l*) of the battery cell **210** may correspond to the second time *k - l* (i.e. may be based on the derivative *∇Vₜ*(*k - l*) and a previous derivative *∇Vₜ*(*k -* 2*l*) of the terminal voltage *Vₜ*).

The approach used in step **358** can be expressed as follows: $\begin{matrix}{x}_{r} \left(k\right) \\ = \left\{\begin{matrix}if i \leq {i}_{cl} then \left\{\begin{matrix}2 & ∇ {V}_{t} \left(k\right) \leq {β}_{1} and ∇ {V}_{t} \left(k-1\right) \leq {β}_{1} or {x}_{r} \left(k-1\right) = 2 , \\ 1 & \begin{matrix}∇ {V}_{t} \left(k\right) \leq {β}_{2} and ∇ {V}_{t} \left(k-1\right) \leq {β}_{2} and ∇ {V}_{t} \left(k\right) > {β}_{1} \\ and ∇ {V}_{t} \left(k-1\right) > {β}_{1} or {x}_{r} \left(k-1\right) = 1 ,\end{matrix} \\ 0 & Otherwise\end{matrix}\right. \\ if i \leq {i}_{cu} then \left\{\begin{matrix}1 & ∇ {V}_{t} \left(k\right) \leq {β}_{2} and ∇ {V}_{t} \left(k-1\right) \leq {β}_{2} or {x}_{r} \left(k-1\right) = 1 , \\ 0 & Otherwise\end{matrix}\right.\end{matrix}\right.\end{matrix}$ (6) where, the battery cell **210** is determined to be in a partially relaxed state if the function outputs a value of 1 and in a fully relaxed state if the function outputs a value of 2. A value of 0 may be output when the battery cell **210** is not partially or fully relaxed, for example when there is transitory behaviour in the dynamics of the battery cell **210.** This may be the case, for example, when fast charging of the battery cell **210** is performed before the load disconnectionThe proposed condition helps to avoid abrupt changes in the relaxation state and adds a safety rule that can only be broken by the current thresholds.

At **360,** a relaxation time for the battery cell **210** corresponding to the determined relaxation state *xᵣ(k)* may be determined. In particular, when the determination of the relaxation state *xᵣ*(*k*) is performed online, a partial or full relaxation state can be determined at a specific time. This can be determined based on the the number of timesteps that have elapsed from the method being triggered (i.e. determining at **352** that the current has below a certain threshold) to the relaxation state *xᵣ*(*k*) meeting the respective condition as defined above.

The method **350** enables the determination of a relaxation state of a battery cell **210** to be performed online. Furthermore, differentiation between partial and full relaxation of the battery cell **210** is provided. The method **350** is performed online (e.g. dynamically) and uses numerical methodologies to determine the relaxation state taking system dynamics such as current, temperature, and state of charge into account, meaning it is not required to determine or store parameter or operation information in advance, and the computational efficiency of the method is increased. In this way, and by measuring voltage directly at the terminal, parameter uncertainties due to cell aging are avoided. The method **350** enables the relaxation state to be determined in an adaptable fashion for different cell types and operating conditions. The method **350** does not depend on the battery cell chemistry itself and can be parameterized to any chemistry and any module to obtain the best performance, for example via appropriate setting of the various thresholds. The method **350** can deal with different implementation issues such as current cutoffs and voltage measurement noise. For example, different BMSs may have different cutoff currents due to secondary sources of energy delivery. Therefore, model- or table-based algorithms will not work properly under the same operating conditions. The presented thresholds enable current cutoffs to be parameterised and can be set to take care of voltage measurement noise. Proper and appropriate implementation of a low pass filter before the voltage measurements are used in the method **350** may also take care of voltage measurement noise. The method **350** represents a discrete state machine with memory, hysteresis, and temporary calculations based on successive window derivatives. The concept of using a derivative directly is enhanced with to minimise measurement noise, false positives, and maintain the relaxation state when appropriate.

The method **350** may also be used to determine a relaxation state and time of the battery pack or module **200.** In particular, the method **350** may also be used to determine a relaxation state of one or more of the other battery cells **210** comprised in the battery module **200** and determine a relaxation state of the battery module **200** based on respective relaxation states of the battery cells **210.** A relaxation metric *xᵣₘ*(*k*) for the battery module **200** may be determined according to: ${x}_{rm} \left(k\right) = {min}_{j = 1}^{n} \left\{{x}_{rj}\left(k\right)\right\} ,$ (7) where n is the number of cells **210** in the module **200,** *xᵣⱼ(k)* is the relaxation state of the *j*-th cell **210,** and *min* is the minimum value of a set of cells **210.** The relaxation time of the battery module **200** may then be determined in the same manner as for the battery cells **210,** as discussed above.

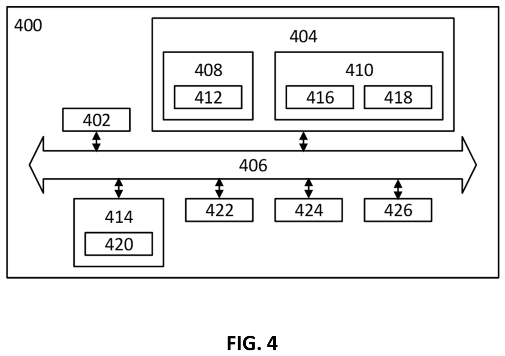

**FIG. 4** is a schematic diagram of a computer system **400** for implementing examples disclosed herein. The computer system **400** is adapted to execute instructions from a computer-readable medium to perform these and/or any of the functions or processing described herein. The computer system **400** may be connected (e.g., networked) to other machines in a LAN, an intranet, an extranet, or the Internet. While only a single device is illustrated, the computer system **400** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **400** may comprise at least one computing device or electronic device capable of including firmware, hardware, and/or executing software instructions to implement the functionality described herein. The computer system **400** may include processing circuitry **402** (e.g., processing circuitry including one or more processor devices or control units), a memory **404,** and a system bus **406.** The computer system **400** may include at least one computing device having the processing circuitry **402.** The system bus **406** provides an interface for system components including, but not limited to, the memory **404** and the processing circuitry **402.** The processing circuitry **402** may include any number of hardware components for conducting data or signal processing or for executing computer code stored in memory **404.** The processing circuitry **402** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **402** may further include computer executable code that controls operation of the programmable device.

The system bus **406** may be any of several types of bus structures that may further interconnect to a memory bus (with or without a memory controller), a peripheral bus, and/or a local bus using any of a variety of bus architectures. The memory **404** may be one or more devices for storing data and/or computer code for completing or facilitating methods described herein. The memory **404** may include database components, object code components, script components, or other types of information structure for supporting the various activities herein. Any distributed or local memory device may be utilized with the systems and methods of this description. The memory **404** may be communicably connected to the processing circuitry **402** (e.g., via a circuit or any other wired, wireless, or network connection) and may include computer code for executing one or more processes described herein. The memory **404** may include non-volatile memory **408** (e.g., read-only memory (ROM), erasable programmable read-only memory (EPROM), electrically erasable programmable read-only memory (EEPROM), etc.), and volatile memory **410** (e.g., random-access memory (RAM)), or any other medium which can be used to carry or store desired program code in the form of machine-executable instructions or data structures and which can be accessed by a computer or other machine with processing circuitry **402.** A basic input/output system (BIOS) **412** may be stored in the non-volatile memory **408** and can include the basic routines that help to transfer information between elements within the computer system **400.**

The computer system **400** may further include or be coupled to a non-transitory computer-readable storage medium such as the storage device **414,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **414** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **414** and/or in the volatile memory **410,** which may include an operating system **416** and/or one or more program modules **418.** All or a portion of the examples disclosed herein may be implemented as a computer program **420** stored on a transitory or non-transitory computer-usable or computer-readable storage medium (e.g., single medium or multiple media), such as the storage device **414,** which includes complex programming instructions (e.g., complex computer-readable program code) to cause the processing circuitry **402** to carry out actions described herein. Thus, the computer-readable program code of the computer program **420** can comprise software instructions for implementing the functionality of the examples described herein when executed by the processing circuitry **402.** In some examples, the storage device **414** may be a computer program product (e.g., readable storage medium) storing the computer program **420** thereon, where at least a portion of a computer program **420** may be loadable (e.g., into a processor) for implementing the functionality of the examples described herein when executed by the processing circuitry **402.** The processing circuitry **402** may serve as a controller or control system for the computer system **400** that is to implement the functionality described herein.

The computer system **400** may include an input device interface **422** configured to receive input and selections to be communicated to the computer system **400** when executing instructions, such as from a keyboard, mouse, touch-sensitive surface, etc. Such input devices may be connected to the processing circuitry **402** through the input device interface **422** coupled to the system bus **406** but can be connected through other interfaces, such as a parallel port, an Institute of Electrical and Electronic Engineers (IEEE) 1394 serial port, a Universal Serial Bus (USB) port, an IR interface, and the like. The computer system **400** may include an output device interface **424** configured to forward output, such as to a display, a video display unit (e.g., a liquid crystal display (LCD) or a cathode ray tube (CRT)). The computer system **400** may include a communications interface **426** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

According to certain examples, there is also disclosed:
Example 1: A computer system (140, 220, 400) for determining a relaxation state, *xᵣ*, of a battery cell (210) online, the computer system (140, 220, 400) comprising processing circuitry (150, 230, 402) configured to: acquire a first terminal voltage, *Vₜ*(*k*), of the battery cell (210) measured at a first time, *k;* acquire a second terminal voltage, *Vₜ*(*k + l*), of the battery cell (210) measured at a second time, *k + l*, a period, *lTₛ,* later than the first time, *k;* determine a relaxation metric, R, for the battery cell (210) based on a difference between the first terminal voltage, *Vₜ*(*k*), and the second terminal voltage, *Vₜ*(*k + l*), over the period, *lTₛ*; and determine a relaxation state, *xᵣ,* of the battery cell (210) online by comparing the determined relaxation metric, R, to a threshold.
Example 2: The computer system (140, 220, 400) of example 1, wherein at least one of the first terminal voltage, *Vₜ*(*k*), and the second terminal voltage, *Vₜ*(*k + l*), is measured directly at a terminal of the battery cell (210).
Example 3: The computer system (140, 220, 400) of example 1 or 2, wherein the processing circuitry (150, 230, 402) is configured to determine the relaxation metric, *R*, using an amplitude factor, *κ*.
Example 4: The computer system (140, 220, 400) of any preceding example, wherein the processing circuitry (150, 230, 402) is configured to determine that the battery cell (210) is in a fully relaxed state if the relaxation metric, *R*, is below a first threshold, *β*₁.
Example 5: The computer system (140, 220, 400) of any preceding example, wherein the processing circuitry (150, 230, 402) is configured to determine that the battery cell (210) is in a partially relaxed state if the relaxation metric, *R*, is above the first threshold, *β*₁, and below a second threshold, *β*₂.
Example 6: The computer system (140, 220, 400) of any preceding example, wherein the processing circuitry (150, 230, 402) is configured to determine the relaxation metric, *R*, according to: $R = \left|\frac{{V}_{t} \left(k+l\right) - {V}_{t} \left(k\right)}{{lT}_{s}}κ\right|$ where *κ* is an amplitude factor.
Example 7: The computer system (140, 220, 400) of any preceding example, wherein the second time, *k + l,* is a current time.
Example 8: The computer system (140, 220, 400) of any preceding example, wherein the processing circuitry (150, 230, 402) is configured to determine the relaxation metric, *R*, dynamically.
Example 9: The computer system (140, 220, 400) of any preceding example, wherein the processing circuitry (150, 230, 402) is configured to acquire the first terminal voltage, *Vₜ*(*k*), in response to determining that a current associated with the battery cell (210) has dropped below a current threshold.
Example 10: The computer system (140, 220, 400) of any preceding example, wherein the processing circuitry (150, 230, 402) is further configured to determine a relaxation time of the battery cell (210) in response to the relaxation metric, *R*, meeting the threshold.
Example 11: The computer system (140, 220, 400) of any preceding example, wherein the processing circuitry (150, 230, 402) is further configured to: determine a relaxation metric, *Rⱼ,* of one or more other battery cells (210) comprised in a battery module (200) comprising the battery cell (210); and determine a relaxation metric, *Rₘ*, of the battery module (200) based on respective relaxation metrics, *Rⱼ,* of the battery cells (210) comprised in the battery module (200).
Example 12: The computer system (140, 220, 400) of example 10, wherein the processing circuitry (150, 230, 402) is configured to determine the relaxation metric, *Rₘ*, for the battery module (200) according to: ${R}_{m} = {min}_{j = 1}^{n} \left\{{R}_{j}\right\} ,$ where n is the number of cells in the module, *Rⱼ* is the relaxation metric of the j-th cell, and *min* is the minimum value of a set of cells.
Example 13: A computer system (140, 220, 400) for determining a relaxation state (*xᵣ*(*k*)) of a battery cell (210) online, the computer system (140, 220, 400) comprising processing circuitry (150, 230, 402) configured to: acquire a first derivative (*∇Vₜ*(*k - l*)) of a terminal voltage (*Vₜ*) of the battery cell (210) between a first time *(k -* 2*l*) and a second time *(k - l*) later than the first time (*k -* 2*l*); acquire a second derivative *(VVt(k))* of the terminal voltage (*Vₜ*) of the battery cell (210) between the second time *(k - l*) and a third time *(k)* later than the second time (*k - l*); and determine the relaxation state (*xᵣ*(*k*)) of the battery cell (210) online by: comparing the first derivative (*∇Vₜ*(*k - l*)) and the second derivative *(VVt(k))* to at least one threshold; or retrieving a previously determined relaxation state (*xᵣ*(*k - l*)) of the battery cell (210).
Example 14: The computer system (140, 220, 400) of example 13, wherein, if a current associated with the battery cell (210) is below a first current threshold (*i_{cl}*) the processing circuitry (150, 230, 402) is configured to determine that the battery cell (210) is in a fully relaxed state if: the first derivative (*∇Vₜ*(*k - l*)) and the second derivative (*∇Vₜ*(*k*)) are below a first threshold (*β*₁); or the previously determined relaxation state (*xᵣ*(*k - l*)) of the battery cell (210) is a fully relaxed state.
Example 15: The computer system (140, 220, 400) of example 13 or 14, wherein, if a current associated with the battery cell (210) is below a first current threshold (*i_{cl}*) the processing circuitry (150, 230, 402) is configured to determine that the battery cell (210) is in a partially relaxed state if: the first derivative (*∇Vₜ*(*k - l*)) and the second derivative (*∇Vₜ*(*k*)) are above a first threshold (*β*₁) and below a second threshold (*β*₂); or the previously determined relaxation state (*xᵣ*(*k - l*)) of the battery cell (210) is a partially relaxed state.
Example 16: The computer system (140, 220, 400) of example 14 or 15, wherein, if a current associated with the battery cell (210) is above the first current threshold (*i_{cl}*) and below a second current threshold (*i_{cu}*), the processing circuitry (150, 230, 402) is configured to determine that the battery cell (210) is in a partially relaxed state if: the first derivative (*∇Vₜ*(*k - l*)) and the second derivative *(VVt(k))* are below a second threshold (*β*₂); or the previously determined relaxation state (*xᵣ(k - l*)) of the battery cell (210) is a partially relaxed state.
Example 17: The computer system (140, 220, 400) of any of examples 14 to 16, wherein the processing circuitry (150, 230, 402) is configured to determine the relaxation state (*xᵣ*(*k*)) of the battery cell (210) online by retrieving a previously determined relaxation state (*xᵣ*(*k - l*)) of the battery cell (210) if the current associated with the battery cell (210) has remained under the relevant current threshold (*i_{cl}, i_{cu}*) between the second time (*k - l*) and the third time (k).
Example 18: The computer system (140, 220, 400) of any of examples 14 to 17, wherein the previously determined relaxation state (*xᵣ*(*k - l*)) of the battery cell (210) corresponds to the second time *(k - l*).
Example 19: The computer system (140, 220, 400) of any of examples 13 to 18, wherein the processing circuitry (150, 230, 402) is configured to determine a derivative *(VVt(k))* according to: $∇ {V}_{t} \left(k\right) = \left|\frac{{V}_{t} \left(k\right) - {V}_{t} \left(k-l\right)}{{lT}_{s}}κ\right|$ where *κ* is an amplitude factor and *Tₛ* is a sampling period.
Example 20: The computer system (140, 220, 400) of any of examples 13 to 19, wherein the third time (*k*) is a current time.
Example 21: The computer system (140, 220, 400) of any of examples 13 to 20, wherein the processing circuitry (150, 230, 402) is configured to acquire the first derivative (*∇Vₜ*(*k - l*)) and the second derivative *(VVt(k))* in response to determining that a current associated with the battery cell (210) has dropped below an initiation current threshold.
Example 22: The computer system (140, 220, 400) of any of examples 13 to 21, wherein the processing circuitry (150, 230, 402) is further configured to determine a relaxation time of the battery cell (210) in response to determining the relaxation state (*xᵣ*(*k*)).
Example 23: The computer system (140, 220, 400) of any of examples 13 to 22, wherein the processing circuitry (150, 230, 402) is further configured to: determine a relaxation state (*xᵣⱼ*(*k*)) of one or more other battery cells (210) comprised in a battery module (200) comprising the battery cell (210); and determine a relaxation state (*xᵣₘ*(*k*)) of the battery module (200) based on respective relaxation states (*xᵣⱼ(k))* of the battery cells (210) comprised in the battery module (200).
Example 24: The computer system (140, 220, 400) of example 23, wherein the processing circuitry (150, 230, 402) is configured to determine a relaxation state (*xᵣₘ*(*k*)) for the battery module (200) according to: ${x}_{rm} \left(k\right) = {min}_{j = 1}^{n} \left\{{x}_{rj}\left(k\right)\right\} ,$ where n is the number of cells in the module, *xᵣⱼ*(*k*) is the relaxation state of the j-th cell, and *min* is the minimum value of a set of cells.
Example 25: A vehicle (100) comprising the computer system (140, 220, 400) of any preceding example.
Example 26: An energy storage system comprising the computer system (140, 220, 400) of any of examples 1 to 24.
Example 27: The energy storage system of example 26 further comprising at least one battery module.
Example 28: A computer-implemented method (300) for determining a relaxation state of a battery cell (210) online, the computer-implemented method (300) comprising: acquiring (304), by processing circuitry (150, 230, 402) of a computer system (140, 220, 400), a first terminal voltage, *Vₜ*(*k*), of the battery cell (210) measured at a first time, *k;* acquiring (306), by the processing circuitry (150, 230, 402), a second terminal voltage, *Vₜ*(*k + l*), of the battery cell (210) measured at a second time, *k + l,* a period, *lTₛ,* later than the first time, *k;* determining (308), by the processing circuitry (150, 230, 402), a relaxation metric, R, based on a difference between the first terminal voltage, *Vₜ*(*k*), and the second terminal voltage, *Vₜ*(*k + l*), over the period, *lTₛ;* and determining (310), by the processing circuitry (150, 230, 402), a relaxation state of the battery cell (210) online by comparing the determined relaxation metric, R, to a threshold.
Example 29: The computer-implemented method (300) of example 28, wherein at least one of the first terminal voltage, *Vₜ*(*k*), and the second terminal voltage, *Vₜ*(*k + l*), is measured directly at a terminal of the battery cell (210).
Example 30: The computer-implemented method (300) of example 28 or 29, comprising determining (308), by the processing circuitry (150, 230, 402), the relaxation metric, R, using an amplitude factor, *κ*.
Example 31: The computer-implemented method (300) of any of examples 28 to 30, comprising determining (310), by the processing circuitry (150, 230, 402), that the battery cell (210) is in a fully relaxed state if the relaxation metric, R, is below a first threshold, *β*₁.
Example 32: The computer-implemented method (300) of any of examples 28 to 31, comprising determining (310), by the processing circuitry (150, 230, 402), that the battery cell (210) is in a partially relaxed state if the relaxation metric, R, is above the first threshold, *β*₁, and below a second threshold, *β*₂.
Example 33: The computer-implemented method (300) of any of examples 28 to 32, comprising determining (308), by the processing circuitry (150, 230, 402), the relaxation metric, R, according to: $R = \left|\frac{{V}_{t} \left(k+l\right) - {V}_{t} \left(k\right)}{{lT}_{s}}κ\right|$ where *κ* is an amplitude factor.
Example 34: The computer-implemented method (300) of any of examples 28 to 33, wherein the second time, *k + l,* is a current time.
Example 35: The computer-implemented method (300) of any of examples 28 to 34, comprising determining (308), by the processing circuitry (150, 230, 402), the relaxation metric, R, dynamically.
Example 36: The computer-implemented method (300) of any of examples 28 to 35, comprising acquiring (304), by the processing circuitry (150, 230, 402), the first terminal voltage, *Vₜ*(*k*), in response to determining (302) that a current associated with the battery cell (210) has dropped below a current threshold.
Example 37: The computer-implemented method (300) of any of examples 28 to 36, further comprising determining (312), by the processing circuitry (150, 230, 402), a relaxation time of the battery cell (210) in response to the relaxation metric, R, meeting the threshold.
Example 38: The computer-implemented method (300) of any of examples 28 to 37, further comprising: determining, by the processing circuitry (150, 230, 402), a relaxation metric, *Rⱼ,* of one or more other battery cells (210) comprised in a battery module (200) comprising the battery cell (210); and determining, by the processing circuitry (150, 230, 402), a relaxation metric, *Rₘ*, of the battery module (200) based on respective relaxation metrics, *Rⱼ,* of the battery cells (210) comprised in the battery module (200).
Example 39: The computer-implemented method (300) of example 38, comprising determining, by the processing circuitry (150, 230, 402), the relaxation metric, *Rₘ*, for the battery module (200) according to: ${R}_{m} = {min}_{j = 1}^{n} \left\{{R}_{j}\right\} ,$ where n is the number of cells in the module, *Rⱼ* is the relaxation metric of the j-th cell, and *min* is the minimum value of a set of cells
Example 40: A computer-implemented method (350) for determining a relaxation state (*xᵣ*(*k*)) of a battery cell (210) online, the computer-implemented method (300) comprising: acquiring (354), by processing circuitry (150, 230, 402) of a computer system (140, 220, 400), a first derivative (*∇Vₜ*(*k - l*)) of a terminal voltage (*Vₜ*) of the battery cell (210) between a first time *(k -* 2*l*) and a second time *(k - l*) later than the first time *(k -* 2*l*); acquiring (356), by the processing circuitry (150, 230, 402), a second derivative *(VVt(k))* of the terminal voltage (*Vₜ*) of the battery cell (210) between the second time *(k - l*) and a third time *(k)* later than the second time (*k - l*); and determining (358), by the processing circuitry (150, 230, 402), a relaxation state (*xᵣ*(*k*)) of the battery cell (210) online by: comparing the first derivative (*∇Vₜ(k - l*)) and the second derivative *(VVt(k))* to at least one threshold; or retrieving a previously determined relaxation state (*xᵣ*(*k - l*)) of the battery cell (210).
Example 41: The computer-implemented method (350) of example 40, wherein the method (350) comprises, if a current associated with the battery cell (210) is below a first current threshold (*i_{cl}*), determining (358), by the processing circuitry (150, 230, 402), that the battery cell (210) is in a fully relaxed state if: the first derivative (*∇Vₜ*(*k - l*)) and the second derivative (*∇Vₜ*(*k*)) are below a first threshold (*β*₁); or the previously determined relaxation state (*xᵣ*(*k - l*)) of the battery cell (210) is a fully relaxed state.
Example 42: The computer-implemented method (350) of example 40 or 41, wherein the method (350) comprises, if a current associated with the battery cell (210) is below a first current threshold (*i_{cl}*), determining (358), by the processing circuitry (150, 230, 402), that the battery cell (210) is in a partially relaxed state if: the first derivative (*∇Vₜ*(*k - l*)) and the second derivative *(VVt(k))* are above a first threshold (*β*₁) and below a second threshold (*β*₂); or the previously determined relaxation state (*xᵣ*(*k - l*)) of the battery cell (210) is a partially relaxed state.
Example 43: The computer-implemented method (350) of example 41 or 42, wherein the method (350) comprises, if a current associated with the battery cell (210) is above the first current threshold (*i_{cl}*) and below a second current threshold (*i_{cu}*), determining (358), by the processing circuitry (150, 230, 402), that the battery cell (210) is in a partially relaxed state if: the first derivative (*∇Vₜ*(*k - l*)) and the second derivative (*∇Vₜ*(*k*)) are below a second threshold (*β*₂); or the previously determined relaxation state (*xᵣ*(*k - l*)) of the battery cell (210) is a partially relaxed state.
Example 44: The computer-implemented method (350) of any of examples 41 to 43, comprising determining (358), by the processing circuitry (150, 230, 402), the relaxation state (*xᵣ*(*k*)) of the battery cell (210) online by retrieving a previously determined relaxation state (*xᵣ*(*k - l*)) of the battery cell (210) if the current associated with the battery cell (210) has remained under the relevant current threshold (*i_{cl}, i_{cu}*) between the second time *(k - l*) and the third time (k).
Example 45: The computer-implemented method (350) of any of examples 41 to 44, wherein the previously determined relaxation state (*xᵣ*(*k - l*)) of the battery cell (210) corresponds to the second time *(k - l*).
Example 46: The computer-implemented method (350) of any of examples 40 to 18, comprising determining, by the processing circuitry (150, 230, 402), a derivative (*∇Vₜ*(*k*)) according to: $∇ {V}_{t} \left(k\right) = \left|\frac{{V}_{t} \left(k\right) - {V}_{t} \left(k-l\right)}{{lT}_{s}}κ\right|$ where *κ* is an amplitude factor and *Tₛ* is a sampling period.
Example 47: The computer-implemented method (350) of any of examples 40 to 46, wherein the third time (*k*) is a current time.
Example 48: The computer-implemented method (350) of any of examples 40 to 47, comprising acquiring (354, 356), by the processing circuitry (150, 230, 402), the first derivative (*∇Vₜ*(*k - l*)) and the second derivative (*∇Vₜ*(*k*)) in response to determining (352) ), by the processing circuitry (150, 230, 402), that a current associated with the battery cell (210) has dropped below an initiation current threshold.
Example 49: The computer-implemented method (350) of any of examples 40 to 48, further comprising determining, by the processing circuitry (150, 230, 402), a relaxation time of the battery cell (210) in response to determining the relaxation state (*xᵣ*(*k*))*.*
Example 50: The computer-implemented method (350) of any of examples 40 to 49, comprising: determining, by the processing circuitry (150, 230, 402), a relaxation state (*xᵣⱼ*(*k*)) of one or more other battery cells (210) comprised in a battery module (200) comprising the battery cell (210); and determining, by the processing circuitry (150, 230, 402), a relaxation state (*xᵣₘ*(*k*)) of the battery module (200) based on respective relaxation states (*xᵣⱼ(k))* of the battery cells (210) comprised in the battery module (200).
Example 51: The computer-implemented method (350) of example 50, comprising determining, by the processing circuitry (150, 230, 402), a relaxation state (*xᵣₘ*(*k*)) for the battery module (200) according to: ${x}_{rm} \left(k\right) = {min}_{j = 1}^{n} \left\{{x}_{rj}\left(k\right)\right\} ,$ where n is the number of cells in the module, *xᵣⱼ(k)* is the relaxation state of the j-th cell, and *min* is the minimum value of a set of cells.
Example 52: A computer program product comprising program code for performing, when executed by processing circuitry (150, 230, 402), the computer-implemented method (300, 350) of any of examples 28 to 51.
Example 53: A non-transitory computer-readable storage medium comprising instructions, which when executed by processing circuitry (150, 230, 402), cause the processing circuitry to perform the computer-implemented method (300, 350) of any of examples 1286 to 51.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (140, 220, 400) for determining a relaxation state (*xᵣ*(*k*)) of a battery cell (210) online, the computer system (140, 220, 400) comprising processing circuitry (150, 230, 402) configured to:
acquire a first derivative (*∇Vₜ*(*k - l*)) of a terminal voltage (*Vₜ*) of the battery cell (210) between a first time *(k -* 2*l*) and a second time *(k - l*) later than the first time *(k -* 2*l*);
acquire a second derivative *(VVt(k))* of the terminal voltage (*Vₜ*) of the battery cell (210) between the second time *(k - i*) and a third time *(k)* later than the second time (*k - l*); and
determine the relaxation state (*xᵣ*(*k*)) of the battery cell (210) online by:
comparing the first derivative (*∇Vₜ*(*k - l*)) and the second derivative *(VVt(k))* to at least one threshold; or
retrieving a previously determined relaxation state (*xᵣ*(*k - l*)) of the battery cell (210).

2. The computer system (140, 220, 400) of claim 1, wherein, if a current associated with the battery cell (210) is below a first current threshold (*i_{cl}*) the processing circuitry (150, 230, 402) is configured to determine that the battery cell (210) is in a fully relaxed state if:
the first derivative (*∇Vₜ*(*k - l*)) and the second derivative (*∇Vₜ*(*k*)) are below a first threshold (*β*₁); or
the previously determined relaxation state (*xᵣ*(*k - l*)) of the battery cell (210) is a fully relaxed state.

3. The computer system (140, 220, 400) of claim 1 or 2, wherein, if a current associated with the battery cell (210) is below a first current threshold (*i_{cl}*) the processing circuitry (150, 230, 402) is configured to determine that the battery cell (210) is in a partially relaxed state if:
the first derivative (*∇Vₜ*(*k - l*)) and the second derivative (*∇Vₜ*(*k*)) are above a first threshold (*β*₁) and below a second threshold (*β*₂); or
the previously determined relaxation state (*xᵣ*(*k - l*)) of the battery cell (210) is a partially relaxed state.

4. The computer system (140, 220, 400) of claim 2 or 3, wherein, if a current associated with the battery cell (210) is above the first current threshold (*i_{cl}*) and below a second current threshold (*i_{cu}*), the processing circuitry (150, 230, 402) is configured to determine that the battery cell (210) is in a partially relaxed state if:
the first derivative (*∇Vₜ*(*k - l*)) and the second derivative (*∇Vₜ*(*k*)) are below a second threshold (*β*₂); or
the previously determined relaxation state (*xᵣ*(*k - l*)) of the battery cell (210) is a partially relaxed state.

5. The computer system (140, 220, 400) of any of claims 2 to 4, wherein the processing circuitry (150, 230, 402) is configured to determine the relaxation state (*xᵣ*(*k*)) of the battery cell (210) online by retrieving a previously determined relaxation state (*xᵣ*(*k - l*)) of the battery cell (210) if the current associated with the battery cell (210) has remained under the relevant current threshold (*i_{cl}, i_{cu}*) between the second time *(k - l*) and the third time (k).

6. The computer system (140, 220, 400) of any of claims 2 to 5, wherein the previously determined relaxation state (*xᵣ*(*k - l*)) of the battery cell (210) corresponds to the second time *(k - l*).

7. The computer system (140, 220, 400) of any preceding claim, wherein the processing circuitry (150, 230, 402) is configured to determine a derivative (*∇Vₜ*(*k*)) according to: $∇ {V}_{t} \left(k\right) = \left|\frac{{V}_{t} \left(k\right) - {V}_{t} \left(k-l\right)}{{lT}_{s}}κ\right|$ where *κ* is an amplitude factor and *Tₛ* is a sampling period.

8. The computer system (140, 220, 400) of any preceding claim, wherein the third time (*k*) is a current time.

9. The computer system (140, 220, 400) of any preceding claim, wherein the processing circuitry (150, 230, 402) is configured to acquire the first derivative (*∇Vₜ*(*k - l*)) and the second derivative (*∇Vₜ*(*k*)) in response to determining that a current associated with the battery cell (210) has dropped below an initiation current threshold.

10. The computer system (140, 220, 400) of any preceding claim, wherein the processing circuitry (150, 230, 402) is further configured to determine a relaxation time of the battery cell (210) in response to determining the relaxation state *(xᵣ(k)).*

11. The computer system (140, 220, 400) of any preceding claim, wherein the processing circuitry (150, 230, 402) is further configured to:
determine a relaxation state (*xᵣⱼ*(*k*)) of one or more other battery cells (210) comprised in a battery module (200) comprising the battery cell (210); and
determine a relaxation state (*xᵣₘ*(*k*)) of the battery module (200) based on respective relaxation states (*xᵣⱼ*(k)) of the battery cells (210) comprised in the battery module (200).

12. A vehicle (100) comprising the computer system (140, 220, 400) of any preceding claim.

13. A computer-implemented method (350) for determining a relaxation state (*xᵣ*(*k*)) of a battery cell (210) online, the computer-implemented method (300) comprising:
acquiring (354), by processing circuitry (150, 230, 402) of a computer system (140, 220, 400), a first derivative (*∇Vₜ*(*k - l*)) of a terminal voltage (*Vₜ*) of the battery cell (210) between a first time *(k -* 2*l*) and a second time *(k - l*) later than the first time *(k -* 2*l*);
acquiring (356), by the processing circuitry (150, 230, 402), a second derivative *(VVt(k))* of the terminal voltage (*Vₜ*) of the battery cell (210) between the second time *(k - i*) and a third time *(k)* later than the second time *(k* - *l*); and
determining (358), by the processing circuitry (150, 230, 402), a relaxation state (*xᵣ*(*k*)) of the battery cell (210) online by:
comparing the first derivative (*∇Vₜ*(*k - l*)) and the second derivative *(VVt(k))* to at least one threshold; or
retrieving a previously determined relaxation state (*xᵣ*(*k - l*)) of the battery cell (210).

14. A computer program product comprising program code for performing, when executed by processing circuitry (150, 230, 402), the computer-implemented method (350) of claim 13.

15. A non-transitory computer-readable storage medium comprising instructions, which when executed by processing circuitry (150, 230, 402), cause the processing circuitry to perform the computer-implemented method (350) of claim 13.
